# EUROPEAN PATENT SPECIFICATION

(11) **EP 4 232 952 B1**
(45) Date of publication and mention of the grant of the patent: **04.03.2026**
(21) Application number: 20816579.5
(22) Date of filing: 20.10.2020
(51) Int. Cl.: G06N 3/02, H03M 7/30

(54) **PRE-PROCESSING IN UPLINK RAN USING NEURAL NETWORK**
VORVERARBEITUNG IM UPLINK RAN UNTER VERWENDUNG EINES NEURONALEN NETZWERKS
PRÉTRAITEMENT DANS UN RÉSEAU D'ACCÈS RADIO (RAN) DE LIAISON MONTANTE À L'AIDE D'UN RÉSEAU NEURONAL

(43) Date of publication of application: 30.08.2023
(73) Proprietor: Nokia Bell Labs France, 91620 Nozay (FR); Telecom Paristech, 91120 Palaiseau (FR)
(72) Inventor: HAJRI, Salah Eddine, 92160 Antony (FR); ZHANG, Chao, 91400 Orsay (FR); BEN-OTHMAN, Ghaya Rekaya, 92160 Antony (FR); ASKRI, Aymen, 91120 Palaiseau (FR)
(74) Representative: Nokia EPO representatives
(86) International application number: PCT/IB2020/000879
(87) International publication number: WO 2022/084707

(56) References cited:
- WO-A1-2020/180221
- US-A1- 2015 372 728
- US-A1- 2019 251 418
- CIVERCHIA FEDERICO ET AL: "Exploiting reconfigurable computing in 5G: a case study of latency critical function: Invited Paper", 2019 IEEE 20TH INTERNATIONAL CONFERENCE ON HIGH PERFORMANCE SWITCHING AND ROUTING (HPSR), IEEE, 26 May 2019 (2019-05-26), pages 1 - 6, XP033601406, DOI: 10.1109/HPSR.2019.8808120
- NOKIA ET AL: "TP of Clean up for functional split", vol. RAN WG3, no. Athens, Greece; 20170213 - 20170217, 12 February 2017 (2017-02-12), XP051213006, Retrieved from the Internet <URL:http://www.3gpp.org/ftp/Meetings_3GPP_SYNC/RAN3/Docs/> [retrieved on 20170212]

## Description

### Technical Field

Various example embodiments relate generally to methods and apparatus for pre-processing in uplink communication in a radio access network. In particular, they relate to methods and apparatus for compression on an interface between a radio head apparatus and a central processing apparatus of a base station in such a radio access network.

### Background

In multiple input-multiple output (MIMO) systems, base stations consisting of a large numbers of antennas simultaneously communicate with multiple spatially separated user equipment over the same frequency resource. Considering the uplink, the user equipment send their signals over several transmission layers which are multiplexed to be transmitted over the radio channel using the same time and frequency resource.

MIMO systems are corner stones of 5G new radio (NR). NR relies heavily on a large number of antenna ports at the base station, an increase in the number of antenna ports/panels at the user equipment side and the capability of the base station to process a high number of transmission layers.

Open RAN, or Open Radio Access Network (O-RAN) is a concept based on interoperability and standardization of RAN elements including a unified interconnection standard for white-box hardware and open source software elements from different vendors. O-RAN architecture integrates a modular base station software stack on off-the-shelf hardware which allows components from various suppliers to operate seamlessly together.

In particular ORAN defines a functional split of the base station including a radio head apparatus and a central processing apparatus connected through a connection medium called fronthaul having limited capacity.

For example in option 7-2x of the ORAN fronthaul specifications, resource element mapping and higher functions are implemented in the central processing apparatus whereas digital beamforming and lower functions are implemented in the radio head apparatus. The fronthaul transmits an IQ sampling sequence of the OFDM signal in the frequency domain for each MIMO transmission layer.

The functional split between the radio head apparatus and the central processing apparatus results from several trade-offs, in particular the required bandwidth for the fronthaul. On the one hand when more functions are performed at the radio head apparatus, there is less strain on the fronthaul. However, this comes at an increased cost in terms of processing and memory capabilities at the radio head apparatus side. Maintenance costs at the radio head apparatus, in particular software upgrade, will also increase. When more functions are put on the central processing apparatus side, costs are lower but the fronthaul capacity becomes a bottleneck.

As high connection density is expected for 5G and beyond systems, the radio head apparatus and the central processing apparatus need to process a high number of transmission layers. When directly treating the received signal at the radio head apparatus with known quantization schemes (like uniform quantization, Lloyd-Max quantization or Grassmanian manifold based quantization), due to the large dimension of the received signal, severe degradation is brought. Consequently, efficient compression is needed at the radio head apparatus to reduce the dimension of the received signal and perform quantization on a signal of smaller dimension.

US2015/372728 discloses a BBU-RRH system with fronthaul compression/decompression. US2019/251418 relates to data compression in networks such as internet and discloses selecting a compression model in a plurality of compression models according to a request of a user. Additional background information can be found in CIVERCHIA FEDERICO ET AL "Exploiting reconfigurable computing in 5G: a case study of latency critical function: Invited Paper".

### Summary

The scope of protection is set out by the independent claims. The embodiments, examples and features, if any, described in this specification that do not fall under the scope of the protection are to be interpreted as examples useful for understanding the various embodiments or examples that fall under the scope of protection.

According to a first aspect, a radio head apparatus is disclosed, for use in a base station of a radio access network, the radio head apparatus being configured to receive compression model information from a central processing apparatus of the base station, receive a data signal from a user equipment over a radio channel, pre-process the data signal, including compress the data signal by using a neural network, the neural network being selected amongst a set of neural networks based on the compression model information, transmit the pre-processed data signal to the central processing apparatus.

According to a second aspect, a method is disclosed for compressing a data signal at a radio head apparatus in a base station of a radio access network, the method comprising receiving compression model information from a central processing apparatus of the base station, receiving a data signal from a user equipment over a radio channel, pre-processing the data signal, including compressing the data signal by using a neural network, the neural network being selected amongst a set of neural networks based on the compression model information, transmitting the pre-processed data signal to the central processing apparatus.

According to a third aspect, a central processing apparatus is disclosed, for use in a base station of a radio access network, the central processing apparatus being configured to receive, through a radio head apparatus of the base station, at least a channel information signal transmitted by a user equipment over a radio channel, obtain, based on the channel information signal, compression model information indicating a neural network to be used for compression by the radio head apparatus amongst a set of neural networks, send the compression model information to the radio head apparatus.

According to a fourth aspect, a method is disclosed for optimizing compression of data signals in a base station of a radio access network, wherein the base station comprises at least a radio head apparatus and a central processing apparatus, the method comprising receiving at the central processing apparatus, through the radio head apparatus, at least a channel information signal transmitted by a user equipment over a radio channel, obtaining by the central processing apparatus, based on the channel information signal, compression model information indicating a neural network to be used for compression by the radio head apparatus amongst a set of neural networks, sending by the central processing apparatus to the radio head apparatus the compression model information.

According to another aspect is disclosed a radio head apparatus and method for compressing data, wherein the radio channel is defined by channel coefficients, and the neural network comprises an input layer receiving the data signal and the channel coefficients, compression layers to compress the data signal and quantization layers to perform quantization of the compressed data signal.

According to another aspect, a radio head apparatus is disclosed, further configured to train the neural network, jointly with the central processing apparatus, by performing updates of weights on iterations of the neural network. A method is also disclosed comprising training the neural network, jointly with the central processing apparatus, by performing updates of weights on iterations of the neural network.

According to another aspect, a central processing apparatus is disclosed which is further configured to obtain, based on the channel information signal, a number of layers to be multiplexed on the channel, wherein the compression model information depends on the number of layers to be multiplexed on the channel. A method is also disclosed comprising obtaining, based on the channel information signal, a number of layers to be multiplexed on the channel, wherein the compression model information depends on the number of layers to be multiplexed on the channel.

According to another aspect, a distribution unit is disclosed, further configured to obtain wideband information from the channel information signal, wherein the compression model information depends on the wideband information. A method is also disclosed comprising obtaining wideband information from the channel information signal, wherein the compression model information depends on the wideband information.

According to another aspect, a central processing apparatus is disclosed, further configured to receive a pre-processed data signal from the radio head apparatus and decode the pre-processed data signal by using a neural network selected amongst the set of neural networks based on the compression model information sent to the radio head apparatus, wherein the neural network comprises a receiving layer for receiving the pre-processed data signal and decoding layers for decoding the pre-processed data signal. A method is also disclosed comprising receiving a pre-processed data signal from the radio head apparatus and decoding the pre-processed data signal by using a neural network selected amongst the set of neural networks based on the compression model information sent to the radio head apparatus, wherein the neural network comprises a receiving layer for receiving the pre-processed data signal and decoding layers for decoding the pre-processed data signal.

According to another aspect, a central processing apparatus is disclosed further configured to train the neural network, jointly with the radio head apparatus, by performing updates of weights on iterations of the neural network. A method is also disclosed for training the neural network, jointly with the radio head apparatus, by performing updates of weights on iterations of the neural network.

In at least one example embodiment the radio head apparatus comprises at least one processor and at least one memory including computer program code. The at least one memory and the computer program code are configured to, with the at least one processor, cause the radio head apparatus to perform a method for compressing a data signal at a radio head apparatus in a base station of a radio access network, as disclosed above.

In at least one example embodiment the central processing apparatus comprises at least one processor and at least one memory including computer program code. The at least one memory and the computer program code are configured to, with the at least one processor, cause the central processing apparatus to perform a method for optimizing compression of data signals in a base station of a radio access network, as disclosed herein.

Generally, the radio head apparatus comprises means for performing one or more or all steps of a method for compressing a data signal in a base station of a radio access network, as disclosed herein. The means may include circuitry configured to perform one or more or all steps of the method for compressing a data signal at a radio head apparatus in a base station of a radio access network, as disclosed herein. The means may include at least one processor and at least one memory including computer program code, wherein the at least one memory and the computer program code are configured to, with the at least one processor, cause the radio head apparatus to perform one or more or all steps of the method for compressing a data signal in a base station of a radio access network, as disclosed herein.

Generally, the central processing apparatus comprises means for performing one or more or all steps of a method for optimizing compression of data signals in a base station of a radio access network, as disclosed herein. The means may include circuitry configured to perform one or more or all steps of the method for optimizing compression of data signals in a base station of a radio access network, as disclosed herein. The means may include at least one processor and at least one memory including computer program code, wherein the at least one memory and the computer program code are configured to, with the at least one processor, cause the central processing apparatus to perform one or more or all steps of the method for optimizing compression of data signals in a base station of a radio access network, as disclosed herein.

At least one example embodiment provides a non-transitory computer-readable medium storing computer-executable instructions that, when executed by at least one processor at a radio head apparatus, cause the radio head apparatus to perform a method for compressing a data signal in a base station of a radio access network, as disclosed herein.

Generally, the computer-executable instructions cause the radio head apparatus to perform one or more or all steps of a method for compressing a data signal in a base station of a radio access network, as disclosed herein.

At least one example embodiment provides a non-transitory computer-readable medium storing computer-executable instructions that, when executed by at least one processor at a central processing apparatus, cause the central processing apparatus to perform a method for optimizing compression of data signals in a base station of a radio access network, as disclosed herein.

Generally, the computer-executable instructions cause the central processing apparatus to perform one or more or all steps of a method for optimizing compression of data signals in a base station of a radio access network, as disclosed herein.

### Brief Description of the Drawings

Example embodiments will now be described with reference to the accompanying drawings, in which:
FIG. 1 is a schematic diagram illustrating a radio access network including user equipment, a radio head apparatus and a central processing apparatus according to the present disclosure;
FIG. 2 is a schematic diagram showing a distributed neural network according to an exemplary embodiment of the present disclosure;
FIG. 3 is flow diagram showing the setup of a compression model between a radio head apparatus and a central processing apparatus according to an exemplary embodiment of the present disclosure;
FIG. 4 is a block diagram of a device that can be used to implement a radio head apparatus and/or a central processing apparatus according to an example implementation.

It should be noted that these figures are intended to illustrate the general characteristics of methods, structure and/or materials utilized in certain example embodiments and to supplement the written description provided below. These drawings are not, however, to scale and may not precisely reflect the exact structural or performance characteristics of any given embodiment, and should not be interpreted as defining or limiting the range of values or properties encompassed by example embodiments. The use of similar or identical reference numbers in the various drawings is intended to indicate the presence of a similar or identical element or feature.

### Detailed Description

Various exemplary embodiments will now be described more fully with reference to the accompanying drawings, including apparatus and method for compression of signals transmitted over a connection medium from a radio head apparatus to a central processing apparatus of a base station in a radio access network. However, specific structural and functional details disclosed herein are merely representative for purposes of describing example embodiments. The exemplary embodiments may be embodied in many alternate forms and should not be construed as limited to only the embodiments set forth herein. It should be understood that there is no intent to limit example embodiments to the particular forms disclosed.

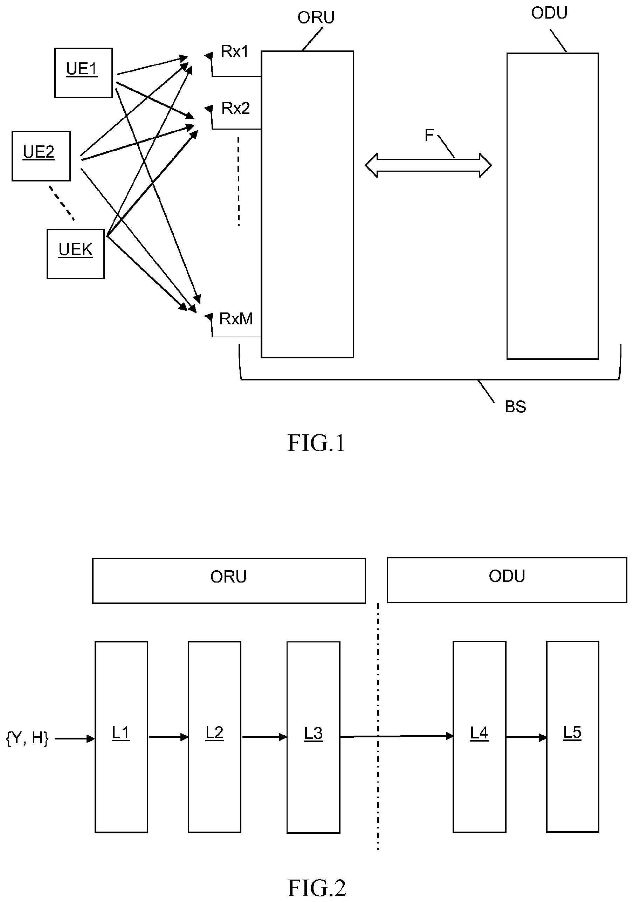

FIG.1 illustrates an example of a radio access network RAN. In this example the RAN includes K user equipment UE1, UE2, ... UEK and a base station BS. The Base station BS comprises a radio head apparatus ORU and a central processing apparatus ODU. The radio head apparatus ORU and the central processing apparatus ODU are connected through a connection medium F also referred to as fronthaul. The radio head apparatus ORU is equipped with M antennas Rx1 to RxM to receive the signals which are simultaneously transmitted via a radio channel by the user equipment UE1 to UEK over the same frequency resource using spatial multiplexing. Each user equipment is associated with at least one spatial layer. Spatial layers are multiplexed for transmission over the channel to the base station BS. The number of spatial layers that can be multiplexed on a channel is referred to as transmission rank, or channel rank and or rank indicator. In the specific example where served user equipment have only one antenna (and therefore transmit over one layer), the transmission rank is equal to the number K of user equipment.

In 5G networks, the radio head apparatus and the central processing apparatus of the base stations need to process a high number of spatial layers. Therefore there is a need for an efficient compression solution (also referred to as dimensional reduction) for transmission over the fronthauls.

In practice the fronthaul compression scheme needs to be adapted to the channel conditions for each radio head apparatus / central processing apparatus interface as explained below. Consider an example with only one user equipment UE1 where the radio head apparatus ORU has only two receive antennas Rx1 and Rx2. When the channel gain between the user equipment UE1 and the first receive antenna Rx1 is strong and the channel gain between the user equipment UE1 and the second receive antenna Rx2 is weak, the observation at the first antenna is more informative and its information should be better preserved by the compression scheme. Similarly, when the channel gain between the user equipment UE1 and the first receive antenna Rx1 is weak and the channel gain between the user equipment UE1 and the second receive antenna Rx2 is strong, the observation at the second antenna is more informative and its information should be better preserved by the compression scheme. This two scenarii lead to completely different requirements for the design of the compression model. Therefore different compression models need to be used for transmission over different fronthauls.

The disclosure uses neural networks to achieve drastic dimensional reduction of the spatial layers received at the radio head apparatus ORU while preserving the performance at the side of the central processing apparatus ODU. An advantage of using neural networks to compress the data to be transmitted over the fronthaul is that neural networks are non-linear and can capture non-linear dependencies. Another advantage is that it facilitates tuning and optimization of the compression model and mitigation of the quantization noise.

Several neural networks are used and, for a specific radio head apparatus / distribution unit interface, an appropriate neural network is selected amongst the set of available neural networks based on a channel information signal received by the radio head apparatus from the user equipment, for example uplink reference signals e.g. SRS (Sound Reference Signal) or channel state information reports e.g. CSI (Channel State Information) reports, for example wideband CSI reports.

As the number of user equipment and number of receive antennas increase, the number of radio head apparatus / central processing apparatus interface scenarii to be taken into account increases drastically. Designing a neural network for each possible scenario is prohibitive. In an embodiment of the disclosure clustering techniques are used to divide the different radio head apparatus / central processing apparatus interfaces into several nonoverlapping clusters, each cluster having its corresponding neural network.

In a specific embodiment the neural network is distributed between the radio head apparatus ORU and the central processing apparatus ODU to perform joint compression/quantization and decoding respectively. In this embodiment the neural network is designed to optimize jointly the compression at the side of the radio head apparatus and the decoding at the side of the central processing apparatus while taking into account the quantization noise. The distributed neural network allows to mimic the whole uplink transmission chain for optimizing the compression model. An example of such an embodiment is explained below in relation to FIG.2.

As illustrated in FIG.2 the neural network comprises on the radio head apparatus side an input layer L1, compression layers L2 and quantization layers L3. On the central processing apparatus side, the neural network comprises a receiving layer L4 and decoding layers L5.

The radio head is processing noisy observations of the original data signal. Assuming a rayleigh-fading channel, the received signal at the radio head apparatus ORU is given as Y = HX+Z, where:
H is the channel matrix, comprising channel coefficients characterizing the channel,
Z is the noise, and
X is the data symbol of the data signal transmitted by the user equipment
X = [x₁, x₂, ..., x_{K}]^{T}, where K is the number of user equipment.

The neural network is designed to recover the data signal X. Because this detection depends on the received signal vector Y and the channel matrix H, the input of the neural network includes information of the received signals and channel coefficients. All or some of the components of the received signals and channel coefficient {Y, H} are employed for the input of the input layer L1 of the neural network. In other words, the size of the input layer of the neural network depends on the transmission rank. When all components are used, the size of the input layer of the neural network is equal to the transmission rank.

The second layers L2 of the neural network perform the compression and the third layers L3 perform quantization before transmission over the fronthaul F. The data received by the central processing apparatus ODU are input to the receiving layer L4 of the neural network. And the decoding layers L5 of the neural network perform decoding to recover an estimate X' of the data signal X.

The neural networks are initially trained offline with training signals and training channel information where the training channels are the channels used to transmit the training signals. The initial offline training results in a first iteration of the neural networks used to configure the radio head apparatus and the central processing apparatus.

For example the training uses observations at the radio head apparatus ORU and associated channel characterization data. For example SRS reference signals or wideband CSI reports received from the user equipment are used to derive channel characterization data (CSI reports comprise PMI -Precoding Matrix Indicator- and the precoding matrix is the inverse of the channel matrix H). In another example, training uses data from simulations.

In an embodiment training includes:
- using the training data to learn a reward function (e.g., the mean square error between the real data and reconstructed data) that evaluates the benefit of dimensional reduction,
- apply the neural network to build a new observation set to optimize a given performance metric (e.g., the reconstruction error),
- improve the neural network based on feedback information sent by the central processing apparatus ODU.

Different possible performance metric can be taken into consideration, such as the latency, the throughput, the Signal-to-Interference-plus-Noise Ratio (SINR).

The neural network may be deepen by implementing more hidden layers.

Following the training process, the radio head apparatus ORU and the central processing apparatus ODU are configured with a set of neural networks for fronthaul compression. This set of neural networks is referred to as first iteration. Each neural network in the set of neural networks is identified by compression model information for example a given index in a configured lookup table.

In another embodiment, some of the fronthaul resources which are saved by implementing the compression scheme are used by the radio head apparatus and the central processing apparatus to jointly train new compression models or update configured ones, online. Online training results in successive iterations of the neural networks. Online training allows to improve the selected network by performing full or partial weights updates on a copy of the neural network. In an exemplary embodiment online training is based on periodic, semi-persistent or aperiodic uplink reference signal for example SRS or channel state information such as CSI reporting from served user equipment.

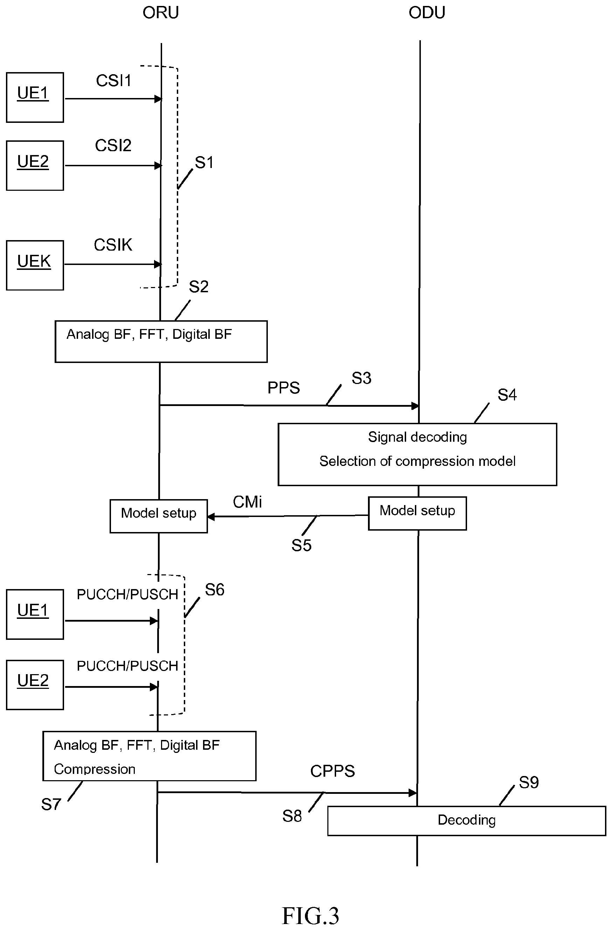

FIG.3 is a flow diagram illustrating an example of fronthaul compression model setup between a radio head apparatus and a central processing apparatus.

At step S1 the radio head apparatus ORU receives CSI reports CSI1 to CSIK from user equipment UE1 to UEK, preferably but not limited to wideband CSI reports. CSI reports includes PMI (Precoding Matrix Indicator), CRI (CSI-RS Resource Indicator), SSBRI (SS/PBCH Resource Block Indicator), and RI (Rank Indicator). The rank indicator gives the transmission rank i.e. the number of layers to be multiplexed on the channel. The transmission rank was previously determined by the base station upon reception of SRS reference signals (not represented in FIG.3). SRS reference signal is used to probe the channel because SRS is transmitted non-precoded, directly on the antenna ports. Therefore the received SRS reflect the channel of each antenna port not including pre-coding. Based on the received SRS the base station evaluates the channel conditions and decide, amongst other things, on a suitable transmission rank adapted to the channel conditions. The transmission rank is sent back to the user equipment in a CSI-RS message (CSI Reference Signal). In response to the CSI-RS reference signal the user equipment provides the CSI report as mentioned above.

At step S2, the radio head apparatus pre-processes the received signals including analog beamforming, FFT (Fast Fourier Transform) and digital beamforming. At step S3 the pre-processed signal PPS is sent over the fronthaul to the central processing apparatus ODU. At step S4, the signal received by the central processing apparatus ODU is decoded and a compression model is selected based at least on the transmission rank which defines the size of the input layer of the neural network to be used. The selected neural network may also depend on other wideband information contained in the CSI reports.

At step S5 a compression model information CMi is sent back to the radio head apparatus ORU. For example the compression model information is an index in a configured lookup table. As this stage, the compression model is setup both in the radio head apparatus ORU and in the central processing apparatus ODU so that the radio head apparatus ORU and the central processing apparatus ODU are ready to perform jointly the selected neural network for compression and decoding. At step S6 the radio head apparatus ORU receives data signal PUCCH/PUSCH from the user equipment UE1 and UE2. At step S7, the radio head apparatus pre-processes the received signals including analog beamforming, FFT (Fast Fourier Transform), digital beamforming and neural network-based compression and quantization. At step S8 the resulting compressed signal CPPS is transmitted over the front haul to the central processing apparatus ODU. And at step S9 the central processing apparatus ODU performs neural network-based decoding of the received signals.

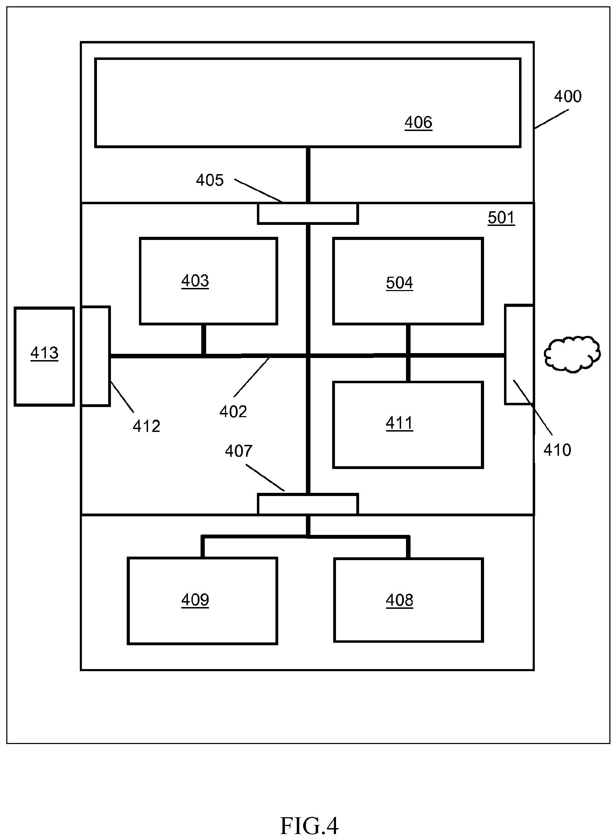

FIG. 4 is a block diagram of a device 400 that, according to an exemplary embodiment, can be used to implement a radio head apparatus and/or a central processing apparatus according to the disclosure. The device 400 comprises a printed circuit board 401 on which a communication bus 402 connects a processor 403, a random access memory 404, a storage medium 411, an interface 405 for connecting a display 406, a series of connectors 407 for connecting user interface devices or modules such as a mouse or trackpad 408 and a keyboard 409, a wireless network interface 410 and a wired network interface 412. Depending on the functionality required, the device may implement only part of the above. Certain modules of FIG. 4 may be internal or connected externally, in which case they do not necessarily form integral part of the device itself. E.g. display 406 may be a display that is connected to a device only under specific circumstances, or the device may be controlled through another device with a display, i.e. no specific display 406 and interface 405 are required for such a device. Memory 411 contains software code which, when executed by processor 403, causes the device to perform the methods described herein. Storage medium 413 is a detachable device such as a USB stick which holds the software code which can be uploaded to memory 411.

It should be appreciated by those skilled in the art that any block diagrams herein represent conceptual views of illustrative circuitry embodying the principles of the disclosure. Similarly, it will be appreciated that any flow charts, flow diagrams, state transition diagrams, and the like represent various processes which may be substantially implemented by circuitry.

Each described function, engine, block, step can be implemented in hardware, software, firmware, middleware, microcode, or any suitable combination thereof. If implemented in software, the functions, engines, blocks of the block diagrams and/or flowchart illustrations can be implemented by computer program instructions / software code, which may be stored or transmitted over a computer-readable medium, or loaded onto a general purpose computer, special purpose computer or other programmable processing apparatus and / or system to produce a machine, such that the computer program instructions or software code which execute on the computer or other programmable processing apparatus, create the means for implementing the functions described herein.

In the present description, functional blocks representing means denoted as "configured to perform ..." (a certain function) shall be understood as functional blocks comprising circuitry that is adapted for performing or configured to perform a certain function. A means being configured to perform a certain function does, hence, not imply that such means necessarily is performing said function (at a given time instant). Moreover, any functional blocks representing an entity configured to perform a function, may correspond to or be implemented as "one or more modules", "one or more devices", "one or more units", etc. When provided by a processor, the functions may be provided by a single dedicated processor, by a single shared processor, or by a plurality of individual processors, some of which may be shared. Moreover, explicit use of the term "processor" or "controller" should not be construed to refer exclusively to hardware capable of executing software, and may implicitly include, without limitation, digital signal processor (DSP) hardware, network processor, application specific integrated circuit (ASIC), field programmable gate array (FPGA), read only memory (ROM) for storing software, random access memory (RAM), and non-volatile storage. Other hardware, conventional or custom, may also be included. Their function may be carried out through the operation of program logic, through dedicated logic, through the interaction of program control and dedicated logic, or even manually, the particular technique being selectable by the implementer as more specifically understood from the context.

Although a flow chart may describe the operations as a sequential process, many of the operations may be performed in parallel, concurrently or simultaneously. In addition, the order of the operations may be re-arranged. A process may be terminated when its operations are completed, but may also have additional steps not included in the figure. A process may correspond to a method, function, procedure, subroutine, subprogram, etc. When a process corresponds to a function, its termination may correspond to a return of the function to the calling function or the main function.

As disclosed herein, the term "storage medium", "computer readable storage medium" or "non-transitory computer readable storage medium" may be any physical media that can be read, written or more generally accessed by a computer / a processing device. Examples of computer storage media include, but are not limited to, a flash drive or other flash memory devices (e.g. memory keys, memory sticks, USB key drive), CD-ROM or other optical storage, DVD, magnetic disk storage or other magnetic storage devices, solid state memory, memory chip, RAM, ROM, EEPROM, smart cards, a relational database management system, a traditional database, or any other suitable medium that can be used to carry or store program code in the form of instructions or data structures which can be read by a computer processor. Also, various forms of computer-readable medium may be used to transmit or carry instructions to a computer, including a router, gateway, server, or other transmission device, wired (coaxial cable, fiber, twisted pair, DSL cable) or wireless (infrared, radio, cellular, microwave). The instructions may include code from any computer-programming language, including, but not limited to, assembly, C, C++, Basic, SQL, MySQL, HTML, PHP, Python, Java, Javascript, etc. Embodiments of a computer-readable medium include, but are not limited to, both computer storage media and communication media including any medium that facilitates transfer of a computer program from one place to another. Specifically, program instructions or computer readable program code to perform embodiments described herein may be stored, temporarily or permanently, in whole or in part, on a non-transitory computer readable medium of a local or remote storage device including one or more storage media.

Furthermore, example embodiments may be implemented by hardware, software, firmware, middleware, microcode, hardware description languages, or any combination thereof. When implemented in software, firmware, middleware or microcode, the program code or code segments to perform the necessary tasks may be stored in a machine or computer readable medium such as a computer readable storage medium. When implemented in software, a processor or processors will perform the necessary tasks. For example, as mentioned above, according to one or more example embodiments, at least one memory may include or store computer program code, and the at least one memory and the computer program code may be configured to, with at least one processor, cause a network element or network device to perform the necessary tasks. Additionally, the processor, memory and example algorithms, encoded as computer program code, serve as means for providing or causing performance of operations discussed herein.

A code segment of computer program code may represent a procedure, function, subprogram, program, routine, subroutine, module, software package, class, or any combination of instructions, data structures or program statements. A code segment may be coupled to another code segment or a hardware circuit by passing and/or receiving information, data, arguments, parameters or memory contents. Information, arguments, parameters, data, etc. may be passed, forwarded, or transmitted via any suitable technique including memory sharing, message passing, token passing, network transmission, etc.

The terms "including" and/or "having," as used herein, are defined as comprising (i.e., open language). Terminology derived from the word "indicating" (e.g., "indicates", "indicator" and "indication") is intended to encompass all the various techniques available for communicating or referencing the object/information being indicated. Some, but not all, examples of techniques available for communicating or referencing the object/information being indicated include the conveyance of the object/information being indicated, the conveyance of an identifier of the object/information being indicated, the conveyance of information used to generate the object/information being indicated, the conveyance of some part or portion of the object/information being indicated, the conveyance of some derivation of the object/information being indicated, and the conveyance of some symbol representing the object/information being indicated.

Although the terms first, second, etc. may be used herein to describe various elements, these elements should not be limited by these terms. These terms are only used to distinguish one element from another. For example, a first element could be termed a second element, and similarly, a second element could be termed a first element, without departing from the scope of this disclosure. As used herein, the term "and/or," includes any and all combinations of one or more of the associated listed items.

According to example embodiments, network elements, network devices, data servers, network resource controllers, network apparatuses, clients, routers, gateways, network nodes, computers, cloud-based servers, web servers, application servers, proxies or proxy servers, or the like, may be (or include) hardware, firmware, hardware executing software or any combination thereof. Such hardware may include processing or control circuitry such as, but not limited to, one or more processors, one or more CPUs, one or more integrated circuits one or more controllers, one or more ALUs, one or more DSPs, one or more microcomputers, one or more FPGAs, one or more SoCs, one or more PLUs, one or more microprocessors, one or more ASICs, or any other device or devices capable of responding to and executing instructions in a defined manner.

As used in this application, the term "circuitry" may refer to one or more or all of the following:
(a) hardware-only circuit implementations (such as implementations in only analog and/or digital circuitry) and
(b) combinations of hardware circuits and software, such as (as applicable):
   (i) a combination of analog and/or digital hardware circuit(s) with software/firmware and
   (ii) any portions of hardware processor(s) with software (including digital signal processor(s)), software, and memory(ies) that work together to cause an apparatus, such as a mobile phone or server, to perform various functions) and
(c) hardware circuit(s) and or processor(s), such as a microprocessor(s) or a portion of a microprocessor(s), that requires software (e.g., firmware) for operation, but the software may not be present when it is not needed for operation.

While aspects of the present disclosure have been particularly shown and described with reference to the embodiments above, it will be understood by those skilled in the art that various additional embodiments may be contemplated by the modification of the disclosed machines, systems and methods without departing from the scope of what is disclosed. Such embodiments should be understood to fall within the scope of the present disclosure as determined based upon the claims.

## Claims

1. A radio head apparatus (ORU) for use in a base station of a radio access network, the radio head apparatus being configured to:
- receive at least a channel information signal transmitted by a user equipment over a radio channel of the radio access network,
- send to a central processing apparatus of the base station at least the channel information signal,
- receive compression model information from a central processing apparatus of the base station, the compression model information being determined by the central processing apparatus based on the channel information signal,
- receive a data signal from a user equipment over a radio channel,
- pre-process the data signal, including compress the data signal by using a neural network, the neural network being selected amongst a set of neural networks based on the compression model information,
- transmit the pre-processed data signal to the central processing apparatus.

2. A method for compressing a data signal at a radio head apparatus (ORU) in a base station of a radio access network, the method comprising:
- receiving (S1) at least a channel information signal transmitted by a user equipment over a radio channel of the radio access network,
- sending (S3) to a central processing apparatus of the base station at least the channel information signal,- receiving (S5) compression model information from a central processing apparatus of the base station, the compression model information being determined by the central processing apparatus based on the channel information signal,
- receiving (S6) a data signal from a user equipment over a radio channel,
- pre-processing (S7) the data signal, including compressing the data signal by using a neural network, the neural network being selected amongst a set of neural networks based on the compression model information,
- transmitting (S8) the pre-processed data signal to the central processing apparatus.

3. A radio head apparatus as claimed in claim 1 or a method for compressing a data signal as claimed in claim 2, wherein the radio channel is defined by channel coefficients, and the neural network comprises an input layer receiving the data signal and the channel coefficients, compression layers to compress the data signal and quantization layers to perform quantization of the compressed data signal.

4. A radio head apparatus as claimed in claims 1 or 3, further configured to train the neural network, jointly with the central processing apparatus, by performing updates of weights on iterations of the neural network.

5. A method for compressing a data signal as claimed in claim 2 or 3, comprising training the neural network, jointly with the central processing apparatus, by performing updates of weights on iterations of the neural network.

6. A central processing apparatus (ODU) for use in a base station of a radio access network, the central processing apparatus being configured to:
- receive, through a radio head apparatus of the base station, at least a channel information signal transmitted by a user equipment over a radio channel,
- obtain, based on the channel information signal, compression model information indicating a neural network to be used for compression by the radio head apparatus amongst a set of neural networks,
- send the compression model information to the radio head apparatus.

7. A central processing apparatus as claimed in claim 6, further configured to obtain, based on the channel information signal, a number of layers to be multiplexed on the channel, wherein the compression model information depends on the number of layers to be multiplexed on the channel.

8. A central processing apparatus as claimed in claim 7, further configured to obtain wideband information from the channel information signal, wherein the compression model information depends on the wideband information.

9. A central processing apparatus as claimed in any of claims 6 to 8, further configured to receive a pre-processed data signal from the radio head apparatus and decode the pre-processed data signal by using a neural network selected amongst the set of neural networks based on the compression model information sent to the radio head apparatus, wherein the neural network comprises a receiving layer for receiving the pre-processed data signal and decoding layers for decoding of the pre-processed data signal.

10. A central processing apparatus as claimed in any of claim 9, further configured to train the neural network, jointly with the radio head apparatus, by performing updates of weights on iterations the neural network.

11. A method for optimizing compression of data signals in a base station of a radio access network, wherein the base station comprises at least a radio head apparatus (ORU) and a central processing apparatus (ODU), the method comprising:
- receiving (S3) at the central processing apparatus, through the radio head apparatus, at least a channel information signal transmitted by a user equipment over a radio channel,
- obtaining (S4) by the central processing apparatus, based on the channel information signal, compression model information indicating a neural network to be used for compression by the radio head apparatus amongst a set of neural networks,
- sending (S5) by the central processing apparatus to the radio head apparatus the compression model information.

12. A method for optimizing compression of data signals as claimed in claim 11, comprising obtaining, based on the channel information signal, a number of layers to be multiplexed on the channel, wherein the compression model information depends on the number of layers to be multiplexed on the channel.

13. A method for optimizing compression of data signals as claimed in claim 12, comprising obtaining wideband information from the channel information signal, wherein the compression model information depends on the wideband information.

14. A method for optimizing compression of data signals as claimed in any of claims 11 to 13, comprising receiving a pre-processed data signal from the radio head apparatus and decoding the pre-processed data signal by using the neural network associated with the compression model information sent to the radio head apparatus, wherein the neural network comprises a receiving layer for receiving the pre-processed data signal and decoding layers for decoding the pre-processed data signal.

15. A method for optimizing compression of data signals as claimed in claim 14, comprising training the neural network, jointly with the radio head apparatus, by performing updates of weights on iterations of the neural network.

## Patentansprüche

1. Funkkopfvorrichtung (ORU) zur Verwendung in einer Basisstation eines Funkzugangsnetzes, wobei die Funkkopfvorrichtung konfiguriert ist zum:
- Empfangen mindestens eines Kanalinformationssignals, das von einem Benutzergerät über einen Funkkanal des Funkzugangsnetzes übertragen wird,
- Senden mindestens des Kanalinformationssignals an eine zentrale Verarbeitungsvorrichtung der Basisstation,
- Empfangen von Kompressionsmodellinformationen von einer zentralen Verarbeitungsvorrichtung der Basisstation, wobei die Kompressionsmodellinformationen von der zentralen Verarbeitungsvorrichtung basierend auf dem Kanalinformationssignal bestimmt werden,
- Empfangen eines Datensignals von einem Benutzergerät über einen Funkkanal,
- Vorverarbeiten des Datensignals, einschließlich Komprimieren des Datensignals unter Verwendung eines neuronalen Netzes, wobei das neuronale Netz aus einem Satz von neuronalen Netzen basierend auf den Kompressionsmodellinformationen ausgewählt wird,
- Übertragen des vorverarbeiteten Datensignals an die zentrale Verarbeitungsvorrichtung.

2. Verfahren zum Komprimieren eines Datensignals an einer Funkkopfvorrichtung (ORU) in einer Basisstation eines Funkzugangsnetzes, wobei das Verfahren umfasst:
- Empfangen (S1) mindestens eines Kanalinformationssignals, das von einem Benutzergerät über einen Funkkanal des Funkzugangsnetzes übertragen wird,
- Senden (S3) mindestens des Kanalinformationssignals an eine zentrale Verarbeitungsvorrichtung der Basisstation,
- Empfangen (S5) von Kompressionsmodellinformationen von einer zentralen Verarbeitungsvorrichtung der Basisstation, wobei die Kompressionsmodellinformationen von der zentralen Verarbeitungsvorrichtung basierend auf dem Kanalinformationssignal bestimmt werden,
- Empfangen (S6) eines Datensignals von einem Benutzergerät über einen Funkkanal,
- Vorverarbeiten (S7) des Datensignals, einschließlich Komprimieren des Datensignals unter Verwendung eines neuronalen Netzes, wobei das neuronale Netz aus einem Satz von neuronalen Netzen basierend auf den Kompressionsmodellinformationen ausgewählt wird,
- Übertragen (S8) des vorverarbeiteten Datensignals an die zentrale Verarbeitungsvorrichtung.

3. Funkkopfvorrichtung nach Anspruch 1 oder Verfahren zum Komprimieren eines Datensignals nach Anspruch 2, wobei der Funkkanal durch Kanalkoeffizienten definiert ist, und das neuronale Netz eine Eingangsschicht zum Empfangen des Datensignals und der Kanalkoeffizienten, Kompressionsschichten zum Komprimieren des Datensignals und Quantisierungsschichten zum Durchführen einer Quantisierung des komprimierten Datensignals umfasst.

4. Funkkopfvorrichtung nach Anspruch 1 oder 3, die ferner konfiguriert ist zum Trainieren des neuronalen Netzes, gemeinsam mit der zentralen Verarbeitungsvorrichtung, durch Durchführen von Gewichtsaktualisierungen bei Iterationen des neuronalen Netzes.

5. Verfahren zum Komprimieren eines Datensignals nach Anspruch 2 oder 3, umfassend Trainieren des neuronalen Netzes, gemeinsam mit der zentralen Verarbeitungsvorrichtung, durch Durchführen von Gewichtsaktualisierungen bei Iterationen des neuronalen Netzes.

6. Zentrale Verarbeitungsvorrichtung (ODU) zur Verwendung in einer Basisstation eines Funkzugangsnetzes, wobei die zentrale Verarbeitungsvorrichtung konfiguriert ist zum:
- Empfangen, durch eine Funkkopfvorrichtung der Basisstation, mindestens eines Kanalinformationssignals, das von einem Benutzergerät über einen Funkkanal übertragen wird,
- Erhalten, basierend auf dem Kanalinformationssignal, von Kompressionsmodellinformationen, die ein neuronales Netz angeben, das für die Kompression durch die Funkkopfvorrichtung aus einem Satz von neuronalen Netzen zu verwenden ist,
- Senden der Kompressionsmodellinformationen an die Funkkopfvorrichtung.

7. Zentrale Verarbeitungsvorrichtung nach Anspruch 6, die ferner konfiguriert ist zum Erhalten, basierend auf dem Kanalinformationssignal, einer Anzahl von Schichten, die auf dem Kanal zu multiplexen sind, wobei die Kompressionsmodellinformationen von der Anzahl der auf dem Kanal zu multiplexenden Schichten abhängen.

8. Zentrale Verarbeitungsvorrichtung nach Anspruch 7, die ferner konfiguriert ist zum Erhalten von Breitbandinformationen aus dem Kanalinformationssignal, wobei die Kompressionsmodellinformationen von den Breitbandinformationen abhängen.

9. Zentrale Verarbeitungsvorrichtung nach einem der Ansprüche 6 bis 8, die ferner konfiguriert ist zum Empfangen eines vorverarbeiteten Datensignals von der Funkkopfvorrichtung und Decodieren des vorverarbeiteten Datensignals unter Verwendung eines neuronalen Netzes, das aus dem Satz von neuronalen Netzen basierend auf den an die Funkkopfvorrichtung gesendeten Kompressionsmodellinformationen ausgewählt wird, wobei das neuronale Netz eine Empfangsschicht zum Empfangen des vorverarbeiteten Datensignals und Decodierungsschichten zum Decodieren des vorverarbeiteten Datensignals umfasst.

10. Zentrale Verarbeitungsvorrichtung nach Anspruch 9, die ferner konfiguriert ist zum Trainieren des neuronalen Netzes, gemeinsam mit der Funkkopfvorrichtung, durch Durchführen von Gewichtsaktualisierungen bei Iterationen des neuronalen Netzes.

11. Verfahren zum Optimieren der Kompression von Datensignalen in einer Basisstation eines Funkzugangsnetzes, wobei die Basisstation mindestens eine Funkkopfvorrichtung (ORU) und eine zentrale Verarbeitungsvorrichtung (ODU) umfasst, wobei das Verfahren umfasst:
- Empfangen (S3) an der zentralen Verarbeitungsvorrichtung, durch die Funkkopfvorrichtung, mindestens eines Kanalinformationssignals, das von einem Benutzergerät über einen Funkkanal übertragen wird,
- Erhalten (S4) durch die zentrale Verarbeitungsvorrichtung, basierend auf dem Kanalinformationssignal, von Kompressionsmodellinformationen, die ein neuronales Netz angeben, das für die Kompression durch die Funkkopfvorrichtung aus einem Satz von neuronalen Netzen zu verwenden ist,
- Senden (S5) der Kompressionsmodellinformationen durch die zentrale Verarbeitungsvorrichtung an die Funkkopfvorrichtung.

12. Verfahren zum Optimieren der Kompression von Datensignalen nach Anspruch 11, umfassend Erhalten, basierend auf dem Kanalinformationssignal, einer Anzahl von Schichten, die auf dem Kanal zu multiplexen sind, wobei die Kompressionsmodellinformationen von der Anzahl der auf dem Kanal zu multiplexenden Schichten abhängen.

13. Verfahren zum Optimieren der Kompression von Datensignalen nach Anspruch 12, umfassend Erhalten von Breitbandinformationen aus dem Kanalinformationssignal, wobei die Kompressionsmodellinformationen von den Breitbandinformationen abhängen.

14. Verfahren zum Optimieren der Kompression von Datensignalen nach einem der Ansprüche 11 bis 13, umfassend Empfangen eines vorverarbeiteten Datensignals von der Funkkopfvorrichtung und Decodieren des vorverarbeiteten Datensignals unter Verwendung des neuronalen Netzes, das den an die Funkkopfvorrichtung gesendeten Kompressionsmodellinformationen zugeordnet ist, wobei das neuronale Netz eine Empfangsschicht zum Empfangen des vorverarbeiteten Datensignals und Decodierungsschichten zum Decodieren des vorverarbeiteten Datensignals umfasst.

15. Verfahren zum Optimieren der Kompression von Datensignalen nach Anspruch 14, umfassend Trainieren des neuronalen Netzes, gemeinsam mit der Funkkopfvorrichtung, durch Durchführen von Gewichtsaktualisierungen bei Iterationen des neuronalen Netzes.

## Revendications

1. Appareil de tête radio (ORU) destiné à être utilisé dans une station de base d'un réseau d'accès radio, l'appareil de tête radio étant configuré pour :
- recevoir au moins un signal d'information de canal transmis par un équipement utilisateur sur un canal radio du réseau d'accès radio,
- envoyer à un appareil de traitement central de la station de base au moins le signal d'information de canal,
- recevoir des informations de modèle de compression d'un appareil de traitement central de la station de base, les informations de modèle de compression étant déterminées par l'appareil de traitement central sur la base du signal d'information de canal,
- recevoir un signal de données d'un équipement utilisateur sur un canal radio,
- prétraiter le signal de données, y compris compresser le signal de données en utilisant un réseau neuronal, le réseau neuronal étant sélectionné parmi un ensemble de réseaux neuronaux sur la base des informations de modèle de compression,
- transmettre le signal de données prétraité à l'appareil de traitement central.

2. Procédé de compression d'un signal de données au niveau d'un appareil de tête radio (ORU) dans une station de base d'un réseau d'accès radio, le procédé comprenant :
- la réception (S1) d'au moins un signal d'information de canal transmis par un équipement utilisateur sur un canal radio du réseau d'accès radio,
- l'envoi (S3) à un appareil de traitement central de la station de base d'au moins le signal d'information de canal,
- la réception (S5) d'informations de modèle de compression d'un appareil de traitement central de la station de base, les informations de modèle de compression étant déterminées par l'appareil de traitement central sur la base du signal d'information de canal,
- la réception (S6) d'un signal de données d'un équipement utilisateur sur un canal radio,
- le prétraitement (S7) du signal de données, y compris la compression du signal de données en utilisant un réseau neuronal, le réseau neuronal étant sélectionné parmi un ensemble de réseaux neuronaux sur la base des informations de modèle de compression,
- la transmission (S8) du signal de données prétraité à l'appareil de traitement central.

3. Appareil de tête radio selon la revendication 1 ou procédé de compression d'un signal de données selon la revendication 2, dans lequel le canal radio est défini par des coefficients de canal, et le réseau neuronal comprend une couche d'entrée recevant le signal de données et les coefficients de canal, des couches de compression pour compresser le signal de données et des couches de quantification pour effectuer la quantification du signal de données compressé.

4. Appareil de tête radio selon les revendications 1 ou 3, configuré en outre pour entraîner le réseau neuronal, conjointement avec l'appareil de traitement central, en effectuant des mises à jour de poids sur des itérations du réseau neuronal.

5. Procédé de compression d'un signal de données selon la revendication 2 ou 3, comprenant l'entraînement du réseau neuronal, conjointement avec l'appareil de traitement central, en effectuant des mises à jour de poids sur des itérations du réseau neuronal.

6. Appareil de traitement central (ODU) destiné à être utilisé dans une station de base d'un réseau d'accès radio, l'appareil de traitement central étant configuré pour :
- recevoir, par l'intermédiaire d'un appareil de tête radio de la station de base, au moins un signal d'information de canal transmis par un équipement utilisateur sur un canal radio,
- obtenir, sur la base du signal d'information de canal, des informations de modèle de compression indiquant un réseau neuronal à utiliser pour la compression par l'appareil de tête radio parmi un ensemble de réseaux neuronaux,
- envoyer les informations de modèle de compression à l'appareil de tête radio.

7. Appareil de traitement central selon la revendication 6, configuré en outre pour obtenir, sur la base du signal d'information de canal, un nombre de couches à multiplexer sur le canal, dans lequel les informations de modèle de compression dépendent du nombre de couches à multiplexer sur le canal.

8. Appareil de traitement central selon la revendication 7, configuré en outre pour obtenir des informations à large bande à partir du signal d'information de canal, dans lequel les informations de modèle de compression dépendent des informations à large bande.

9. Appareil de traitement central selon l'une quelconque des revendications 6 à 8, configuré en outre pour recevoir un signal de données prétraité de l'appareil de tête radio et décoder le signal de données prétraité en utilisant un réseau neuronal sélectionné parmi l'ensemble de réseaux neuronaux sur la base des informations de modèle de compression envoyées à l'appareil de tête radio, dans lequel le réseau neuronal comprend une couche de réception pour recevoir le signal de données prétraité et des couches de décodage pour le décodage du signal de données prétraité.

10. Appareil de traitement central selon la revendication 9, configuré en outre pour entraîner le réseau neuronal, conjointement avec l'appareil de tête radio, en effectuant des mises à jour de poids sur des itérations du réseau neuronal.

11. Procédé d'optimisation de la compression de signaux de données dans une station de base d'un réseau d'accès radio, dans lequel la station de base comprend au moins un appareil de tête radio (ORU) et un appareil de traitement central (ODU), le procédé comprenant :
- la réception (S3) au niveau de l'appareil de traitement central, par l'intermédiaire de l'appareil de tête radio, d'au moins un signal d'information de canal transmis par un équipement utilisateur sur un canal radio,
- l'obtention (S4) par l'appareil de traitement central, sur la base du signal d'information de canal, d'informations de modèle de compression indiquant un réseau neuronal à utiliser pour la compression par l'appareil de tête radio parmi un ensemble de réseaux neuronaux,
- l'envoi (S5) par l'appareil de traitement central à l'appareil de tête radio des informations de modèle de compression.

12. Procédé d'optimisation de la compression de signaux de données selon la revendication 11, comprenant l'obtention, sur la base du signal d'information de canal, d'un nombre de couches à multiplexer sur le canal, dans lequel les informations de modèle de compression dépendent du nombre de couches à multiplexer sur le canal.

13. Procédé d'optimisation de la compression de signaux de données selon la revendication 12, comprenant l'obtention d'informations à large bande à partir du signal d'information de canal, dans lequel les informations de modèle de compression dépendent des informations à large bande.

14. Procédé d'optimisation de la compression de signaux de données selon l'une quelconque des revendications 11 à 13, comprenant la réception d'un signal de données prétraité de l'appareil de tête radio et le décodage du signal de données prétraité en utilisant le réseau neuronal associé aux informations de modèle de compression envoyées à l'appareil de tête radio, dans lequel le réseau neuronal comprend une couche de réception pour recevoir le signal de données prétraité et des couches de décodage pour décoder le signal de données prétraité.

15. Procédé d'optimisation de la compression de signaux de données selon la revendication 14, comprenant l'entraînement du réseau neuronal, conjointement avec l'appareil de tête radio, en effectuant des mises à jour de poids sur des itérations du réseau neuronal.
